# FASCICULE DE BREVET EUROPEEN

(11) **EP 3 401 848 B1**
(45) Date de publication et mention de la délivrance du brevet: **28.07.2021**
(21) Numéro de dépôt: 18171613.5
(22) Date de dépôt: 09.05.2018
(51) Int. Cl.: G06N 10/00, H01L 29/66

(54) **DISPOSITIF QUANTIQUE A QUBITS DE SPIN**
QUANTENVORRICHTUNG MIT SPIN-QUBITS
QUANTUM DEVICE WITH SPIN QUBITS

(30) Priorité: 11.05.2017 FR 1754156
(43) Date de publication de la demande: 14.11.2018
(73) Titulaire: COMMISSARIAT À L'ÉNERGIE ATOMIQUE ET AUX ÉNERGIES ALTERNATIVES, 75015 Paris (FR); Centre National de la Recherche Scientifique, 75794 Paris Cedex 16 (FR)
(72) Inventeur: HUTIN, Louis, 38950 Saint-Martin-le-Vinoux (FR); DE FRANCESCHI, Silvano, 38000 Grenoble (FR); MEUNIER, Tristan, 38000 Grenoble (FR); VINET, Maud, 38640 Claix (FR)
(74) Mandataire: Brevalex

(56) Documents cités:
- VANDERSYPEN L M K ET AL: "Interfacing spin qubits in quantum dots and donors - hot, dense and coherent", ARXIV.ORG, CORNELL UNIVERSITY LIBRARY, 201 OLIN LIBRARY CORNELL UNIVERSITY ITHACA, NY 14853, 18 décembre 2016 (2016-12-18), XP080745178,
- AUSTIN G. FOWLER ET AL: "Surface codes: Towards practical large-scale quantum computation", PHYSICAL REVIEW A (ATOMIC, MOLECULAR, AND OPTICAL PHYSICS), vol. 86, no. 3, 26 octobre 2012 (2012-10-26), XP055332246, USA ISSN: 1050-2947, DOI: 10.1103/PhysRevA.86.032324
- HANSON R ET AL: "Single-shot readout of electron spins in a semiconductor quantum dot", PHYSICA E - LOW-DIMENSIONAL SYSTEMS AND NANOSTRUCTURES, ELSEVIER SCIENCE BV, NL, vol. 34, no. 1-2, 1 août 2006 (2006-08-01) , pages 1-5, XP028038213, ISSN: 1386-9477, DOI: 10.1016/J.PHYSE.2006.02.010 [extrait le 2006-08-01]

## Description

### DOMAINE TECHNIQUE ET ART ANTÉRIEUR

L'invention concerne le domaine du traitement de l'information quantique, ou de l'informatique quantique. L'invention concerne notamment un dispositif quantique à bits quantiques (appelé quantum bits) ou qubits de spin.

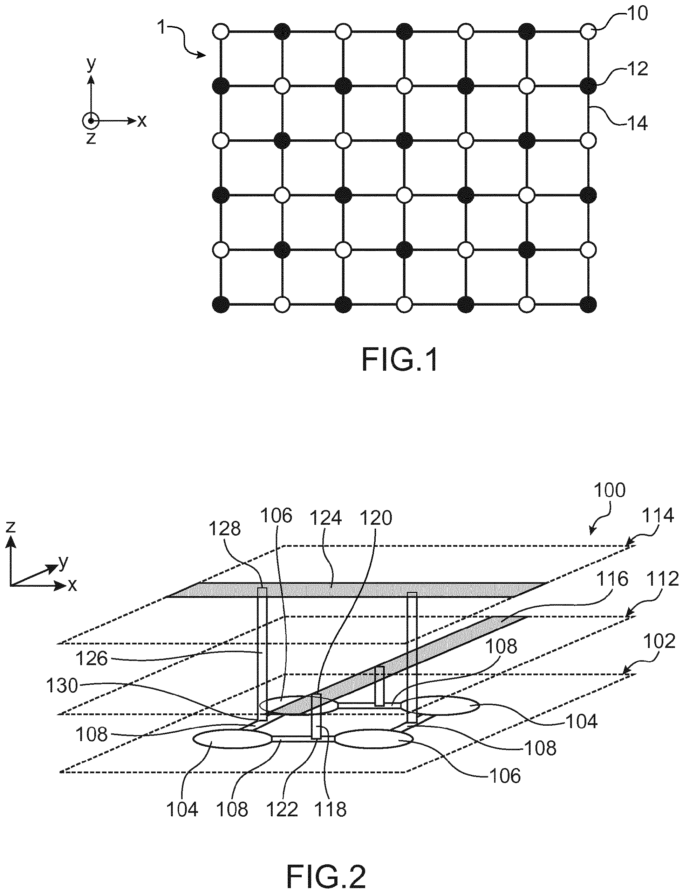

Dans ce domaine, afin de pallier les imperfections des qubits, il existe des codes de corrections d'erreurs, appelés « surface code », qui permettent de réparer la perte d'information quantique et de réaliser ainsi des calculs quantiques de grande complexité. Pour implémenter ce type de code correcteur d'erreurs, des matrices de qubits sont réalisées, par exemple à partir de silicium, sous la forme de matrice bidimensionnelle 1 telle que représentée sur la figure 1.

Sur cette figure 1, les ronds blancs référencés 10 représentent des qubits de donnée et les ronds noirs référencés 12 représentent des qubits de mesure. Les qubits 10, 12 voisins sont interconnectés les uns aux autres par des barrières tunnels 14. Dans cette matrice 1, les qubits de donnée 10 sont disposés en quinconce les uns par rapport aux autres, et les qubits de mesure 12 sont disposés en quinconce les uns par rapport aux autres. Ces qubits 10, 12 sont alignés et disposés en formant des lignes et des colonnes. Enfin, les qubits 10, 12 sont agencés tels que chaque qubit de donnée 10 soit relié à deux (pour un qubit de donnée 10 se trouvant dans un coin de la matrice), trois (pour un qubit de donnée 10 se trouvant sur un bord de la matrice) ou quatre (pour tous les autres qubits de donnée 10 ne se trouvant ni dans un coin ni sur un bord de la matrice) qubits de mesure 12, et que chaque qubit de mesure 12 soit relié à deux (pour un qubit de mesure 12 se trouvant dans un coin de la matrice), trois (pour un qubit de mesure 12 se trouvant sur un bord de la matrice) ou quatre (pour tous les autres qubits de mesure 12 ne se trouvant ni dans un coin ni sur un bord de la matrice) qubits de donnée 10.

Pour qu'une telle matrice 1 de qubits soit fonctionnelle, au moins chacun des qubits de mesure 12 (et éventuellement les qubits de données 10) doit être couplé à un élément de détection (non représenté sur la figure 1) dont le fonctionnement est assimilable à celui d'un transistor à électron unique ou « Single Electron Transistor » (SET), permettant de détecter si une charge est présente ou non sur le qubit auquel l'élément de détection est couplé. Cet élément de détection doit aussi pouvoir être utilisé pour envoyer ou recevoir un porteur de charge (électron ou un trou) depuis ou vers au moins un des qubits de mesure 12 (et si possible également sur au moins un des qubits de donnée 10).

Un premier problème qui se pose avec une telle matrice 1 de qubits concerne l'adressage des qubits 10, 12 qui doit être réalisé dans une telle structure. En effet, chacun des qubits de mesure 12, et éventuellement chacun des qubits de donnée 10, doit être relié à une connexion électrique formant un accès électrique à ce qubit depuis l'extérieur de la matrice 1. En considérant par exemple une matrice de qubits 3 x 3 (neuf qubits disposés en formant un carré de trois lignes et trois colonnes), la réalisation des connexions électriques d'adressage à chacun de ces neuf qubits nécessite au moins deux niveaux d'interconnexions électriques : un premier niveau pour le qubit central de cette matrice et un deuxième niveau pour les autres qubits se trouvant autour de ce qubit central. Cela découle du fait que la distance entre les qubits est trop réduite pour que toutes les connexions électriques reliées aux qubits puissent être sorties dans un même niveau d'interconnexions électriques. En considérant une matrice 5 x 5, soit vingt-cinq qubits, au moins trois niveaux d'interconnexions électriques sont nécessaires. De manière générale, pour une matrice de n x n qubits, n/2 niveaux d'interconnexions électriques sont nécessaires lorsque n est pair, et (n+1)/2 niveaux d'interconnexions électriques sont nécessaires lorsque n est impair. Lorsque n est grand, par exemple supérieur à environ 40 voire supérieur à environ 30, le nombre de niveaux d'interconnexions électriques devient bien trop important pour que ces niveaux soient réalisables.

Un deuxième problème posé par une telle matrice 1 concerne la réalisation des éléments de détection devant être couplés aux qubits. En effet, étant données les dimensions recherchées pour la réalisation des qubits (deux qubits voisins étant par exemple espacés l'un de l'autre d'une distance comprise entre environ 5 nm et 100 nm, et chaque qubit a des dimensions latérales, par exemple un diamètre, comprises entre environ 5 nm et 100 nm), la réalisation de ces éléments de détection au sein de cette matrice 1 de qubits est difficilement envisageable.

En outre, un troisième problème posé par une telle matrice 1 est que comme pour la réalisation de l'adressage des qubits, la réalisation de l'adressage des éléments de détection est problématique en raison du nombre important de connexions électriques devant être réalisées.

Le document « Interfacing spin qubits in quantum dots and donors - hot, dense and coherent » rédigé par Vandersypen L. M. K. et al, arxiv.org, Cornell University, 18 décembre 2016 (2016-12-18) décrit un dispositif à qubits de spins comportant au moins : une première matrice de qubits reliées entre eux par des barrières tunnels ; des moyens d'adressage des qubits configurés pour contrôler par effet de champ la conduction des barrières tunnels.

### EXPOSÉ DE L'INVENTION

Un but de la présente invention est de proposer un dispositif quantique à qubits de spins dans lequel l'adressage de qubits disposés en formant une matrice bidimensionnelle est réalisé avec un nombre réduit de niveaux d'interconnexions électriques.

Pour cela, la présente invention propose un dispositif quantique à qubits de spins selon la revendication indépendante 1.

Dans ce dispositif, il est donc proposé d'adresser les qubits de donnée et les qubits de mesure non pas avec des connexions électriques reliées directement à ces qubits, mais avec des grilles électrostatiques réalisées par des vias électriquement conducteurs disposés en regard des barrières tunnels reliant les qubits. Ces vias électriquement conducteurs sont polarisés grâce à des portions conductrices de niveaux de métallisations. Chaque via conducteur forme une grille de contrôle électrostatique d'une des barrières tunnels reliant les qubits entre eux. Ces grilles de contrôle sont agencées de manière matricielle.

Le contrôle d'un qubit individuel peut provenir de l'adressage en ligne et en colonne des barrières tunnels (par exemple au nombre de deux, trois ou quatre suivant la disposition du qubit adressé au sein de la matrice) reliées à ce qubit et contrôlées par les grilles électrostatiques formées en regard de ces barrières tunnels.

Il est possible que dans des modes d'optimisation, un contrôle des potentiels électrostatiques des barrières tunnels des qubits adjacents au qubit adressé soit également réalisé car le contrôle des potentiels électrostatiques des barrières tunnels reliées au qubit adressé peut impacter les qubits adjacents reliés à ces barrières tunnels. Toutefois, lors de l'adressage d'un qubit, ce qubit est relié à un plus grand nombre de barrières tunnels dont les potentiels électrostatiques sont contrôlés par rapport aux qubits voisins du fait de l'adressage en lignes et colonnes réalisé.

Avec de tels moyens d'adressage, il est possible de réaliser un adressage individuel de chaque qubit de donnée ou de mesure en utilisant seulement deux niveaux de métallisation, et cela quelle que soit la taille de la matrice de qubits et du nombre de qubits inclus dans cette matrice.

Les barrières tunnels peuvent être formées par des portions de semi-conducteur plus étroites que celles formant les qubits. De telles portions de semi-conducteur plus étroites sont appelées « constrictions ».

Chaque qubit de donnée peut être relié à au moins deux qubits de mesure voisins et chaque qubit de mesure peut être relié à au moins deux qubits de donnée voisins.

Le dispositif quantique peut être tel que :
- dans la première matrice, les qubits de donnée et les qubits de mesure sont alignés selon une première et une deuxième directions perpendiculaires l'une par rapport à l'autre, formant des lignes et des colonnes de la première matrice ;
- les deuxièmes extrémités des premiers vias électriquement conducteurs sont disposées en regard d'une partie des barrières tunnels, appelées premières barrières tunnels, reliant chacune un des qubits de donnée et un des qubits de mesure voisins et disposés sur une même ligne de la première matrice ;
- les deuxièmes extrémités des deuxièmes vias électriquement conducteurs sont disposées en regard d'une autres partie des barrières tunnels, appelées deuxièmes barrières tunnels, reliant chacune un des qubits de donnée et un des qubits de mesure voisins et disposés sur une même colonne de la première matrice.

Chacune des premières portions électriquement conductrices peut être reliée aux premières extrémités des premiers vias conducteurs dont les deuxièmes extrémités sont disposées en regard des premières barrières tunnels reliant des qubits de données et des qubits de mesure disposés sur deux colonnes voisines de la première matrice, et chacune des deuxièmes portions électriquement conductrices peut être reliée aux premières extrémités des deuxièmes vias conducteurs dont les deuxièmes extrémités sont disposées en regard des deuxièmes barrières tunnels reliant des qubits de données et des qubits de mesure disposés sur deux lignes voisines de la première matrice.

Dans un premier mode de réalisation, le dispositif quantique peut comporter en outre une deuxième couche de semi-conducteur comprenant une deuxième matrice de détecteurs de charge, comportant chacun par exemple une boîte quantique (ou « quantum dot »), chacun des qubits de mesure pouvant être relié électriquement à un des détecteurs de charge par une première portion de semi-conducteur s'étendant entre les première et deuxième couches de semi-conducteur, chacune des premières portions de semi-conducteur pouvant être couplée à au moins une grille apte à, ou configurée pour, contrôler un couplage tunnel entre le détecteur de charge et le qubit de mesure reliés par ladite première portion de semi-conducteur. Dans ce cas, chacune des premières grilles contrôle la conduction électrique au sein d'une des premières portions de semi-conducteur qui relie chacune un des qubits de mesure à l'un des détecteurs de charge. Dans cette configuration, les détecteurs de charge sont réalisés au sein d'un niveau de semi-conducteur différent de celui dans lequel se trouvent les qubits de donnée et les qubits de mesure. Une telle configuration résout les problèmes de densité de réalisation des qubits rencontrés dans les structures de l'art antérieur, et permet donc de réaliser les qubits de donnée et les qubits de mesure avec de faibles dimensions (deux qubits voisins étant par exemple espacés l'un de l'autre d'une distance comprise entre environ 5 nm et 100 nm, et chaque qubit ayant des dimensions latérales, par exemple un diamètre, comprises entre environ 5 nm et 100 nm). Les contraintes liées à la réalisation de la deuxième matrice de détecteurs de charge sont également réduites.

De plus, dans le premier mode de réalisation, chacune des premières portions de semi-conducteur peut être couplée à une première grille et à une deuxième grille aptes à, ou configurée pour, contrôler un couplage tunnel entre le détecteur de charge et le qubit de mesure reliés par ladite première portion de semi-conducteur et qui sont distinctes et espacées l'une de l'autre, et le dispositif quantique peut comporter en outre :
- des troisièmes portions électriquement conductrices chacune reliée aux premières grilles disposées autour des premières portions de semi-conducteur reliées au moins aux qubits de mesure disposés sur une même colonne de la première matrice ;
- des quatrièmes portions électriquement conductrices chacune reliée aux deuxièmes grilles disposées autour des premières portions de semi-conducteur reliées au moins aux qubits de mesure disposés sur une même ligne de la première matrice.

Dans le premier mode de réalisation, les premières et deuxièmes grilles peuvent être enrobantes et être chacune disposée autour d'une des premières portions de semi-conducteur.

Dans un deuxième mode de réalisation, le dispositif quantique peut comporter en outre une deuxième couche de semi-conducteur et une deuxième matrice de détecteurs de charge formés par des deuxièmes portions de semi-conducteur s'étendant entre les première et deuxième couches de semi-conducteur, chacune desdites deuxièmes portions de semi-conducteur pouvant être reliée par au moins une troisième barrière tunnel à au moins un des qubits de mesure disposés, dans le plan de la première couche de semi-conducteur, autour de ladite deuxième portion de semi-conducteur.

Contrairement au premier mode de réalisation dans lequel les détecteurs de charge sont réalisés au sein de la deuxième couche de semi-conducteur et dans lequel les premières portions de semi-conducteur servent à relier ces détecteurs de charge au moins aux qubits de mesure, le deuxième mode de réalisation propose de réaliser les détecteurs de charge en utilisant les deuxièmes portions de semi-conducteur qui s'étendent entre les première et deuxième couches de semi-conducteur. Dans ce deuxième mode de réalisation, l'adressage des détecteurs de charge n'est pas réalisé par l'intermédiaire des premières et deuxièmes grilles formées autour des premières portions de semi-conducteur, mais par l'intermédiaire des moyens d'adressage des qubits de donnée et des qubits de mesure qui permettent également d'agir sur la conduction des troisièmes barrières tunnels qui relient les détecteurs de charge au moins aux qubits de mesure. Ce deuxième mode de réalisation a pour avantage de ne pas avoir à réaliser de grilles enrobantes entre les deux couches de semi-conducteur.

Selon une configuration avantageuse de ce deuxième mode de réalisation, chacune des deuxièmes portions de semi-conducteur peut être reliée par au moins deux troisièmes barrières tunnels à au moins deux qubits de mesure disposés, dans le plan de la première couche de semi-conducteur, autour de ladite deuxième portion de semi-conducteur. Le dispositif quantique selon cette configuration a pour avantage de réduire le nombre de détecteurs de charge utilisés grâce à la mise en commun des détecteurs de charge pour au moins plusieurs qubits de mesure.

De manière avantageuse, chacun des qubits de donnée peut être relié à un des détecteurs de charge.

Dans ce cas, dans le premier mode de réalisation, chacun des qubits de donnée peut être relié électriquement à un des détecteurs de charge par une des premières portions de semi-conducteur qui peut être couplée à au moins une grille apte à, ou configurée pour, contrôler un couplage tunnel entre le détecteur de charge et le qubit de donnée reliés par ladite première portion de semi-conducteur. De plus, comme pour les premières portions de semi-conducteur reliant les détecteurs de charge aux qubits de mesure, chacune des premières portions de semi-conducteur reliant les détecteurs de charge aux qubits de donnée peut être couplée à une première grille et à une deuxième grille aptes à, ou configurées pour, contrôler un couplage tunnel entre le détecteur de charge et le qubit de donnée reliés par ladite première portion de semi-conducteur et qui sont distinctes et espacées l'une de l'autre, et avec dans ce cas :
- des troisièmes portions électriquement conductrices chacune reliée aux premières grilles disposées autour des premières portions de semi-conducteur reliées aux qubits de donnée disposés sur une même colonne de la première matrice ;
- des quatrièmes portions électriquement conductrices chacune reliée aux deuxièmes grilles disposées autour des premières portions de semi-conducteur reliées aux qubits de donnée disposés sur une même ligne de la première matrice.

Pour ces premières portions de semi-conducteur reliant les détecteurs de charge aux qubits de donnée, il est possible que les première et deuxième grilles soient enrobantes et chacune disposée autour d'une de ces premières portions de semi-conducteur.

Dans le deuxième mode de réalisation, lorsque chacun des qubits de donnée est relié à un des détecteurs de charge, chacune desdites deuxièmes portions de semi-conducteur est reliée par au moins une troisième barrière tunnel à au moins un des qubits de mesure ou de donné disposés, dans le plan de la première couche de semi-conducteur, autour de ladite deuxième portion de semi-conducteur. De plus, chacune des deuxièmes portions de semi-conducteur peut être reliée par quatre troisièmes barrières tunnels à au moins deux qubits de mesure et deux qubits de donnée disposés, dans le plan de la première couche de semi-conducteur, autour de ladite deuxième portion de semi-conducteur.

La première couche de semi-conducteur peut être disposée entre la deuxième couche de semi-conducteur et les premier et deuxième niveaux de métallisations.

La deuxième couche de semi-conducteur peut comporter en outre des portions dopées aptes à, ou configurées pour, former des réservoirs de porteurs de charges auxquels les détecteurs de charge sont reliés par l'intermédiaire de quatrièmes barrières tunnels.

Selon une configuration avantageuse, chacune des portions dopées peut être reliée à plusieurs détecteurs de charge disposés sur une même ligne ou une même colonne de la deuxième matrice. Cette mise en commun des portions dopées à plusieurs détecteurs de charge est avantageuse car il n'est pas nécessaire de réaliser une commande individuelle des quatrièmes barrières tunnels.

Le dispositif quantique peut comporter en outre des deuxièmes grilles aptes à, ou configurées pour, contrôler par effet de champ la conduction de chacune des quatrièmes barrières tunnels. Les deuxièmes grilles peuvent être formées par des cinquièmes portions électriquement conductrices s'étendant parallèlement aux lignes ou aux colonnes de la première matrice, disposées en regard des quatrièmes barrières tunnel et espacées des quatrièmes barrières tunnel par une deuxième couche diélectrique. En outre, les cinquièmes portions électriquement conductrices peuvent être formées dans un niveau conducteur tel que la deuxième couche de semi-conducteur soit disposée entre la première couche de semi-conducteur et le niveau conducteur.

Chacune des cinquièmes portions électriquement conductrices peut former plusieurs deuxièmes grilles.

L'invention porte également sur un procédé selon la revendication indépendante 14.

### BRÈVE DESCRIPTION DES DESSINS

La présente invention sera mieux comprise à la lecture de la description en faisant référence aux dessins annexés sur lesquels :
- la figure 1 représente schématiquement une matrice bidimensionnelle de qubits de spins ;
- les figures 2 à 5 correspondent à différentes vues schématiques d'une partie d'un dispositif quantique, objet de la présente invention, selon un premier mode de réalisation ;
- la figure 6 représente schématiquement une partie d'un dispositif quantique, objet de la présente invention, selon un deuxième mode de réalisation ;
- les figures 7A à 7L représentent les étapes d'un procédé de réalisation d'un dispositif quantique, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère tout d'abord aux figures 2 à 5 qui représentent schématiquement une partie d'un dispositif quantique 100 selon un premier mode de réalisation.

Le dispositif quantique 100 comporte des qubits de spin agencés en matrice de type « surface code » telle que précédemment décrite en lien avec la figure 1. Les qubits de spin sont réalisés au sein d'une couche de semi-conducteur 102, par exemple de silicium. La référence 104 désigne les qubits de donnée et la référence 106 désigne les qubits de mesure. Chacun des qubits 104, 106 a des dimensions latérales (dans le plan (X,Y)), par exemple un diamètre ou un côté, comprises entre environ 5 nm et 100 nm, et avantageusement égales à environ 40 nm, et une épaisseur par exemple comprise entre environ 5 nm et 30 nm. La distance entre deux qubits 104, 106 voisins agencés sur une même ligne ou une même colonne de la matrice est par exemple comprise entre environ 5 nm et 100 nm, et avantageusement de l'ordre de 40 nm.

Dans cette matrice, les qubits de donnée 104 sont disposés en quinconce les uns par rapport aux autres, et les qubits de mesure 106 sont disposés en quinconce les uns par rapport aux autres. Ces qubits 104, 106 sont disposés en formant des lignes et des colonnes de la matrice. Enfin, les qubits 104, 106 sont agencés tels que chaque qubit de donnée 104 soit relié à deux (lorsque le qubit se trouve dans un coin de la matrice), trois (lorsque le qubit se trouve au niveau d'un bord de la matrice) ou quatre (pour les autres qubits ne se trouvant pas dans un coin ou au niveau d'un bord de la matrice) qubits de mesure 106, et que de même, chaque qubit de mesure 106 soit relié à deux, trois ou quatre qubits de donnée 104.

Les qubits 104, 106 sont interconnectés les uns aux autres par des barrières tunnels 108 correspondant à des portions de semi-conducteur de la couche 102. L'espacement de deux qubits voisins disposés sur une même ligne ou une même colonne de la matrice correspond à la longueur d'une des barrières tunnels 108. Les portions de semi-conducteur formant les barrières tunnels 108 ont par exemple une épaisseur similaire à celles formant les qubits 104, 106, c'est-à-dire comprise entre environ 5 nm et 30 nm, et ont une largeur inférieure aux dimensions latérales (par exemple le diamètre) des qubits 104, 106, par exemple comprise entre environ 5 nm et 40 nm.

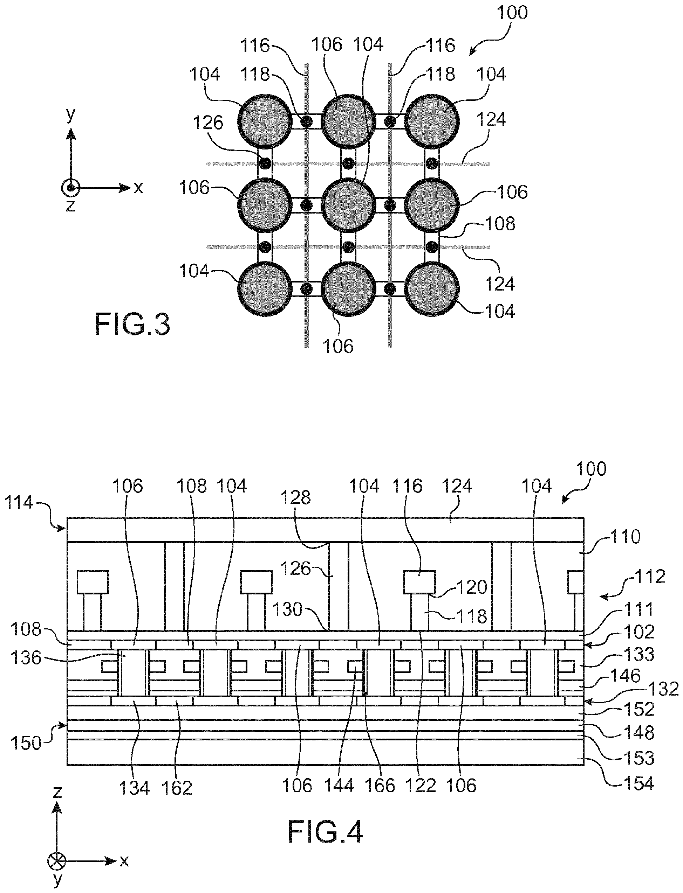

La figure 2 correspond à une vue en perspective schématique d'une partie du dispositif 100, sur laquelle seulement deux qubits de donnée 104 et deux qubits de mesure 106 sont représentés. La figure 3 correspond à une vue de dessus schématique d'une partie du dispositif 100, sur laquelle une matrice 3 x 3 formée de cinq qubits de donnée 104 et quatre qubits de mesure 106 est représentée.

Comme représenté sur la figure 4, la couche de semi-conducteur 102 dans laquelle sont réalisés les qubits 104, 106 est recouverte d'une couche diélectrique 111 et d'un matériau diélectrique 110. Deux niveaux de métallisations sont formés au sein de ce matériau diélectrique 110. Un premier de deux niveaux, référencé 112, est disposé entre la couche de semi-conducteur 102 et un deuxième des deux niveaux, référencé 114.

Le matériau diélectrique 110 est par exemple du SiO₂, ou avantageusement un matériau diélectrique ayant une constante diélectrique de valeur inférieure à celle du SiO₂ (matériau dit « Low-k »), comme par exemple du SiOCH ou du SiO₂ poreux.

Des métallisations du premier niveau 112, appelées premières portions conductrices 116, forment des portions longitudinales s'étendant selon une première direction, c'est-à-dire ayant leur plus grande dimension sensiblement parallèle à cette première direction. Cette première direction est sensiblement parallèle aux lignes ou aux colonnes de la matrice de qubits 104, 106. Sur le premier mode de réalisation représenté sur les figures 2 à 5, les premières portions conductrices 116 s'étendent parallèlement à l'axe Y, c'est-à-dire parallèlement aux colonnes de la matrice de qubits 104, 106 représentée sur ces figures. Chacune des premières portions conductrices 116 s'étend en regard des barrières tunnels 108 reliant les qubits 104, 106 formant deux colonnes voisines de la matrice. Ainsi, pour une matrice de qubits 104, 106 de dimensions n x n, le premier niveau de métallisations 112 comporte (n-1) premières portions conductrices 116 chacune s'étendant au-dessus des barrières tunnels 108 reliant les qubits 104, 106 appartenant à deux colonnes voisines de la matrice.

Des premiers vias électriquement conducteurs 118 sont réalisés dans la partie du matériau diélectrique 110 se trouvant entre le premier niveau de métallisations 112 et la couche diélectrique 111. Comme les premières portions conductrices 116, ces premiers vias 118 sont disposés en regard des barrières tunnels 108 qui relient chacune deux qubits 104, 106 voisins appartenant à deux colonnes voisines. Les premiers vias 118 comportent chacun une première extrémité 120 reliée électriquement à l'une des premières portions conductrices 116, et une deuxième extrémité 122 proche d'une des barrières tunnels 108 mais telle que la couche diélectrique 111 soit présente entre cette deuxième extrémité 122 et ladite barrière tunnel 108. L'épaisseur de cette couche diélectrique 111 est par exemple comprise entre environ 2 nm et 20 nm.

Le matériau de la couche diélectrique 111 est tel qu'il comporte avantageusement une constante diélectrique supérieure à celle du SiO₂ (matériau dit « High-k »), et correspond par exemple à un bicouche SiO₂/HfO₂, SiO₂/nitrure de silicium, ou comporte du SiCO.

Des métallisations du deuxième niveau 114, appelées deuxièmes portions conductrices 124, forment des portions longitudinales s'étendant selon une deuxième direction sensiblement perpendiculaire à la première direction des premières portions conductrices 116. Sur les figures 2 à 4, les deuxièmes portions conductrices 124 s'étendent parallèlement à l'axe X, c'est-à-dire parallèlement aux lignes de la matrice de qubits 104, 106 représentée sur ces figures. Chacune des deuxièmes portions conductrices 124 s'étend en regard des barrières tunnels 108 reliant les qubits 104, 106 formant deux lignes voisines de la matrice. Ainsi, pour une matrice de qubits 104, 106 de dimensions n x n, le deuxième niveau de métallisations 114 comporte (n-1) deuxièmes portions conductrices 124 chacune s'étendant au-dessus des barrières tunnels 108 reliant les qubits 104, 106 appartenant à deux lignes voisines de la matrice.

Des deuxièmes vias électriquement conducteurs 126 sont réalisés dans la partie du matériau diélectrique 110 se trouvant entre le deuxième niveau de métallisations 114 et la couche diélectrique 111. Comme les deuxièmes portions conductrices 124, ces deuxième vias 126 sont disposés en regard des barrières tunnels 108 qui relient chacune deux qubits 104, 106 voisins appartenant à deux lignes voisines. Les deuxièmes vias 126 comportent chacun une première extrémité 128 reliée électriquement à l'une des deuxièmes portions conductrices 124, et une deuxième extrémité 130 proche d'une des barrières tunnels 108 mais telle que la couche diélectrique 111 soit présente entre cette deuxième extrémité 130 et ladite barrière tunnel 108.

Dans le dispositif 100, l'adressage des qubits 104 et 106 n'est pas réalisé par l'intermédiaire de connexions électriques chacune reliée directement à l'un des qubits 104, 106, mais par l'intermédiaire des portions conductrices 116, 124 et des vias conducteurs 118, 126 qui permettent de contrôler la localisation du qubit adressé via le contrôle par effet de champ de la conduction au sein des barrières tunnels 108, de manière analogue à des grilles de transistors à effet de champ. Les portions conductrices 116, 124 et les vias conducteurs 118, 126 peuvent donc être vus comme formant des grilles contrôlant la conduction électrique des liaisons tunnels entre les qubits 104, 106. Sur l'exemple de la figure 3, le potentiel électrique au sein du qubit de donnée 104 se trouvant au centre de la matrice représentée est contrôlé par l'intermédiaire des deux premières portions conductrices 116 et des deux deuxièmes portions conductrices 124 visibles sur cette figure et qui sont adjacentes (vue de dessus) à ce qubit 104, et par les premiers et deuxièmes vias conducteurs 118, 126 agencés au-dessus des barrières tunnels 108 reliant ce qubit de donnée 104 aux quatre qubits de mesure 106 se trouvant autour de ce qubit de donnée 104.

Pour une matrice de n x n qubits 104, 106, chacune des portions conductrices 116, 124 permet d'agir sur n barrières tunnels 108, et donc sur les potentiels électriques de 2n qubits 104, 106 (ceux reliés par lesdites n barrières tunnels 108). Quelle que soit la valeur de n, seuls deux niveaux de métallisations permettent d'adresser l'ensemble des qubits d'une matrice de n x n qubits. Pour une telle matrice de n x n qubits, 2(n-1) portions conductrices et 2n(n-1) vias conducteurs permettent donc d'adresser individuellement chacun des qubits de la matrice. Etant donné que chaque via conducteur agit sur une barrière tunnel 108 reliant deux qubits 104, 106, il est possible d'adresser individuellement de manière simultanée au plus n(n-1) qubits.

Outre la couche de semi-conducteur 102, appelée première couche de semi-conducteur 102, dans laquelle sont réalisés les qubits 104, 106 et les barrières tunnels 108, et les niveaux de métallisations 112, 114 formant les moyens d'adressage des qubits 104, 106, le dispositif 100 comporte également une deuxième couche de semi-conducteur 132 dans laquelle sont réalisés des détecteurs de charge 134 destinés à réaliser une détection de charges et également à échanger des charges (électrons ou trous) avec les qubits 104, 106. Ces détecteurs de charge 134 présentent des caractéristiques physiques (taille, espacement, matériaux, etc.) analogues à celles des qubits de données 104 et des qubits de mesure 106.

La première couche de semi-conducteur 102 est disposée entre la deuxième couche de semi-conducteur 132 et le premier niveau de métallisations 112. Une autre couche diélectrique 133 est interposée entre la première couche de semi-conducteur 102 et la deuxième couche de semi-conducteur 132.

Chaque détecteur de charge 134 est formé par une portion de la deuxième couche de semi-conducteur 132, de dimensions par exemple similaires à celles des qubits 104, 106. Chaque détecteur de charge 134 a par exemple une section, dans le plan de la deuxième couche de semi-conducteur 132, de forme sensiblement circulaire de diamètre égal à environ 40 nm. Deux détecteurs de charge 134 voisins sont par exemple espacés l'un de l'autre d'une distance comprise entre environ 5 nm et 100 nm, par exemple de l'ordre de 40 nm.

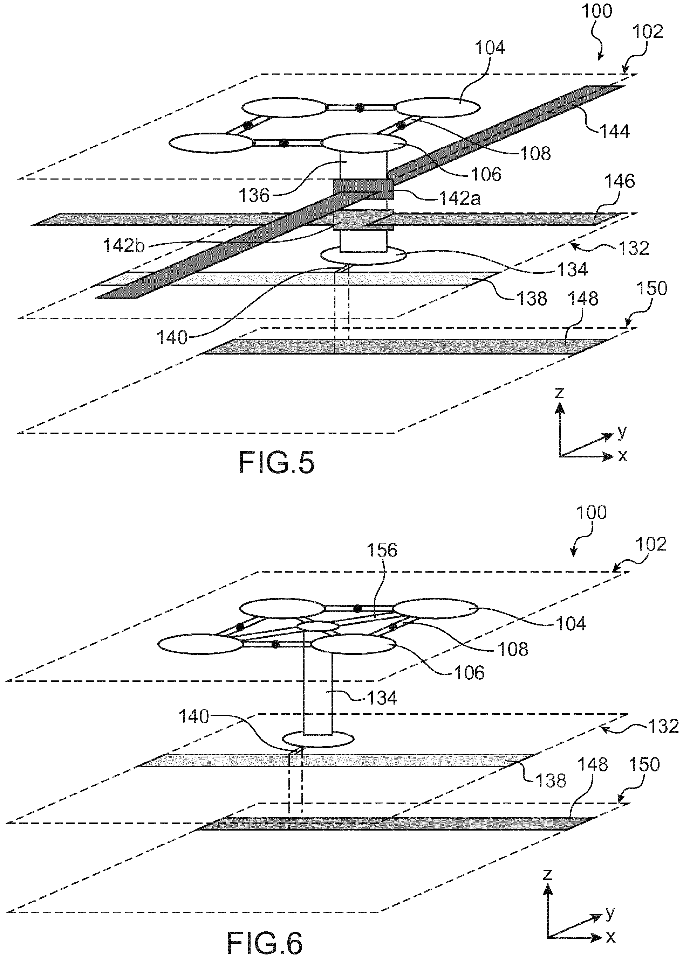

Au moins chaque qubit de mesure 106, et éventuellement chaque qubit de donnée 104, est relié à un des détecteurs de charge 134 disposé en regard de ce qubit 104, 106. Les liaisons entre les qubits de mesure 106 (et éventuellement les qubits de donnée 104) et les détecteurs de charge 134 sont formées par des portions de semi-conducteur 136 formant des piliers s'étendant entre les couches 102 et 132, dans la couche diélectrique 133. Le nombre de détecteurs de charge 134 réalisés dans la deuxième couche 132 et le nombre de portions de semi-conducteur 136 sont donc chacun égaux au nombre de qubits de mesure 106 réalisés dans la première couche 102 lorsque les détecteurs de charge 134 ne sont reliés qu'aux qubits de mesure 106, et sont chacun égaux au nombre totale de qubits 104, 106 lorsque les détecteurs de charge 134 sont reliés aux qubits de mesure 106 et aux qubits de donnée 104. Sur la figure 5, un seul détecteur de charge 134 et une seule portion de semi-conducteur 136 sont représentés.

En outre, dans ce premier mode de réalisation, les détecteurs de charge 134 sont disposés en formant une deuxième matrice similaire à la première matrice formée par les qubits 104, 106, et le dispositif 100 comporte donc n² ou n²/2 détecteurs de charge 134 (dans le cas d'une matrice n x n de qubits 104, 106).

Chaque détecteur de charge 134 est relié à un réservoir de porteurs de charges (électrons ou trous) permettant d'alimenter en porteurs de charge les détecteurs de charge 134, puis les qubits 106 et éventuellement 104. Dans le premier mode de réalisation décrit ici, les détecteurs de charge 134 disposés sur une même ligne ou sur une même colonne de la deuxième matrice de détecteurs de charge 134 sont reliés à une même portion dopée 138 de la deuxième couche de semi-conducteur 132 s'étendant parallèlement à cette ligne ou cette colonne de détecteurs de charge 134. Sur l'exemple de la figure 5, les portions dopées 138 s'étendent parallèlement à l'axe X, c'est-à-dire parallèlement aux lignes de la matrice de détecteurs de charge 134. En variante, les portions dopées 138 peuvent s'étendre parallèlement à l'axe Y, c'est-à-dire parallèlement aux colonnes de la matrice de détecteurs de charge 134.

Les détecteurs de charge 134 sont reliés aux portions dopées 138 par des barrières tunnels 140. Ces barrières tunnels 140 sont par exemple de nature similaire aux barrières tunnels 108 reliant les qubits 104, 106 entre eux, c'est-à-dire formées par des portions de semi-conducteur de dimensions et de forme telles qu'elles forment des barrières tunnels.

Le passage des porteurs de charges entre les qubits de mesure 106, ou éventuellement les qubits de donnée 104, et les détecteurs de charge 134 est contrôlé par des grilles 142 chacune formée autour des portions 136. Sur la figure 5, une première grille 142a et une deuxième grille 142b sont formées par des portions de matériau conducteur entourant une des portions 136, un matériau diélectrique 166 étant présent entre cette portion 136 et ce matériau conducteur de grille. Ces grilles 142a, 142b ont un fonctionnement analogue à celui d'une grille d'un transistor et contrôlent le passage des porteurs de charges dans les portions 136, entre l'un des détecteurs de charge 134 et l'un des qubits de donnée ou de mesure 104, 106, de manière électrostatique et en fonction du potentiel électrique qui leur est appliqué.

Dans le premier mode de réalisation décrit ici, l'adressage des grilles 142a, 142b est réalisé en faisant appel à des troisièmes portions conductrices 144 longitudinales qui s'étendent selon une direction parallèle aux lignes ou aux colonnes de la matrice de qubits 104, 106 (parallèlement aux colonnes sur l'exemple de la figure 5, c'est-à-dire parallèlement à l'axe Y), et à des quatrièmes portions conductrices 146 longitudinales s'étendant selon une direction perpendiculaire à celle des troisièmes portions conductrices 144 (parallèlement à l'axe X sur la figure 5). Afin de pouvoir adresser individuellement chaque qubit de mesure 106 et éventuellement chaque qubit de donnée 104, chacune des portions 136 est entourée de deux grilles 142a, 142b formées par deux portions conductrices distinctes et espacées l'une de l'autre. La première grille 142a est reliée à une des troisièmes portions conductrices 144 et la deuxième grille 142b est reliée à une des quatrièmes portions conductrices 146.

Chacune des troisièmes et quatrièmes portions conductrices 144, 146 est reliée à l'une des deux grilles 142a, 142b formée autour de chacune des portions 136 disposées sur une même ligne ou une même colonne. Ainsi, sur l'exemple de la figure 5, la troisième portion conductrice 144 représentée est reliée électriquement à la première grille 142a représentée ainsi qu'aux autres premières grilles 142a se trouvant sur la colonne à laquelle appartient la première grille 142a représentée. La quatrième portion conductrice 146 représentée est reliée électriquement à la deuxième grille 142b représentée ainsi qu'aux autres deuxièmes grilles 142b se trouvant sur la ligne à laquelle appartient la deuxième grille 142b représentée.

Le passage des porteurs de charges dans une des portions 136 est commandé en appliquant des potentiels électriques adéquats sur la troisième portion conductrice 144 et sur la quatrième portion conductrice 146 qui sont reliées aux première et deuxième grilles 142a, 142b qui entourent cette portion 136.

Les troisièmes et quatrièmes portions conductrices 144, 146 sont disposées dans la couche diélectrique 133.

Pour commander le passage de porteurs de charges dans les barrières tunnels 140 qui relient les détecteurs de charge 134 aux portions dopées 138, des cinquièmes portions conductrices 148 sont formées au sein d'un niveau conducteur 150 disposé sous la deuxième couche de semi-conducteur 132. Il n'est pas nécessaire que les barrières tunnels 140 soient adressées individuellement, mais cela est possible. Chacune de ces cinquièmes portions conductrices 148 peut commander simultanément la conductivité d'un ensemble de barrières tunnels 140, par exemple toutes les barrières tunnels 140 associées aux détecteurs de charge 134 se trouvant sur une même ligne, comme c'est le cas sur la figure 5, ou sur une même colonne. Ces cinquièmes portions conductrices 148 comportent par exemple au moins un métal et/ou du silicium polycristallin.

Une autre couche diélectrique 152 est interposée entre le niveau conducteur 150 et la deuxième couche de semi-conducteur 132. Cette couche diélectrique 152 comprend par exemple un diélectrique à forte permittivité (« High-k ») ou de l'oxyde. Le niveau conducteur 150 repose sur un ensemble de maintien comprenant une couche diélectrique 153, comportant par exemple de l'oxyde, et une couche support 154, par exemple une couche massive, ou « bulk », de semi-conducteur. L'épaisseur de cette couche diélectrique 152 est assez mince, par exemple comprise entre environ 2 nm et 25 nm pour que les cinquièmes portions conductrices 148 contrôlent les barrières tunnels 140 de manière électrostatique, de manière analogue à une grille de transistor. Pour cela, les cinquièmes portions conductrices 148 sont disposées en regard des barrières tunnels 140.

La figure 6 représente schématiquement une partie du dispositif quantique 100 selon un deuxième mode de réalisation.

Dans ce deuxième mode de réalisation, chaque détecteur de charge 134 est formé par une portion de semi-conducteur s'étendant entre les deux couches de semiconducteurs 102, 132.

En outre, dans la configuration particulière représentée sur la figure 6, et contrairement au premier mode de réalisation dans lequel chaque qubit de mesure 106 et éventuellement chaque qubit de donnée 104 est relié directement à un détecteur de charge 134 qui lui est propre, chaque détecteur de charge 134 est ici commun à plusieurs qubits de mesure 106, et éventuellement commun à plusieurs qubits de mesure 106 et qubits de donnée 104. Sur cet exemple, chaque détecteur de charge 134 est commun à quatre qubits 104, 106 disposés en formant une matrice 2 x 2 et qui, vu de dessus, sont disposés autour du détecteur de charge 134. Dans ce deuxième mode de réalisation, le dispositif 100 comporte donc un nombre de détecteurs de charge 134 égal à n²/4.

En plus des barrières tunnels 108 reliant les qubits 104, 106 entre eux, d'autres portions de semi-conducteur de la couche 102 forment des barrières tunnels 156 reliant chacun des détecteurs de charge 134 à chacun des qubits de donnée et de mesure 104, 106 associés à ce détecteur de charge 134.

En variante, les détecteurs de charge 134 peuvent n'être reliés qu'aux qubits de mesure 106. Dans ce cas, chaque détecteur de charge 134 peut être relié à deux qubits de mesure 106 par l'intermédiaire de deux barrières tunnels 156.

Comme dans le premier mode de réalisation, chaque détecteur de charge 134 est relié à un réservoir de porteurs de charges permettant d'alimenter en porteurs de charges les détecteurs de charge 134, formé par une portion dopée 138 de la couche de semi-conducteur 132. De plus, les détecteurs de charge 134 sont reliés aux portions dopées 138 par les barrières tunnels 140 qui, comme dans le premier mode de réalisation, sont commandées par les cinquièmes portions conductrices 148 formées au sein du niveau conducteur 150.

Contrairement au premier mode de réalisation dans lequel les liaisons entre les qubits de donnée et de mesure 104, 106 et les détecteurs de charge 134 sont commandées par les grilles 142 et les troisièmes et quatrièmes portions conductrices 144, 146, ces barrières tunnels 156 sont ici commandées par un couplage tunnel modulé via les premières et deuxièmes portions conductrices 116, 126 qui agissent indirectement sur ces liaisons 156. Les grilles formées par les portions 116, 126 peuvent « pousser » la fonction d'onde de la charge du qubit considéré vers le détecteur de charge 134, ce qui équivaut à baisser la barrière tunnel 156. Ces grilles peuvent également éloigner cette fonction d'onde et ainsi augmenter le niveau de la barrière tunnel 156.

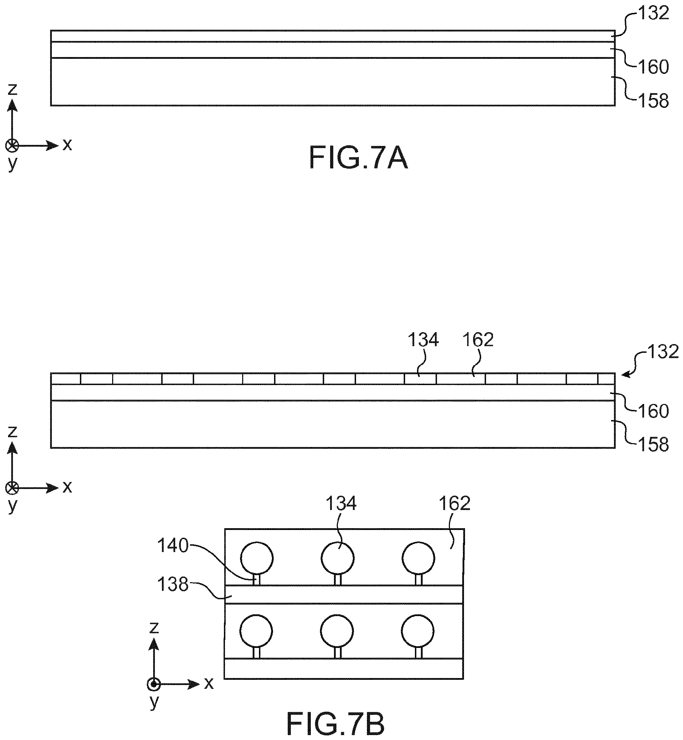

Un procédé de réalisation du dispositif quantique 100 selon un mode de réalisation particulier est maintenant décrit en lien avec les figures 7A à 7L.

Le dispositif 100 est réalisé à partir d'un substrat SOI comportant une couche massive de semi-conducteur 158, par exemple de silicium, une couche diélectrique enterrée 160, par exemple de SiO₂, et d'une couche superficielle de semi-conducteur, par exemple de silicium, correspondant à la deuxième couche de semi-conducteur 132 (figure 7A). L'épaisseur de la deuxième couche de semi-conducteur 132 est par exemple comprise entre environ 5 nm et 30 nm.

Comme représenté sur la figure 7B, la deuxième couche de semi-conducteur 132 est gravée telle que des portions restantes de cette couche forment les détecteurs de charge 134 espacés les uns des autres. Dans l'exemple décrit ici, les détecteurs de charge 134 sont réalisés sous la forme de portions de semi-conducteur de section, dans le plan de la couche 132 (plan (X,Y)), de forme sensiblement circulaire. D'autres portions 138 restantes de cette couche de semi-conducteur, présentes entre les détecteurs de charge 134, sont dopées afin de former des réservoirs de porteurs de charge. Enfin, d'autres portions restantes de cette couche de semi-conducteur forment les quatrièmes barrières tunnels 140.

Un matériau diélectrique 162 est ensuite déposé afin de remplir les espaces formés dans la couche 132, entre les détecteurs de charge 134, les portions 138 et les barrières tunnels 140. Une planarisation est mise en œuvre afin d'éliminer le matériau diélectrique 162 déposé, formant ainsi une isolation électrique autour de ces éléments.

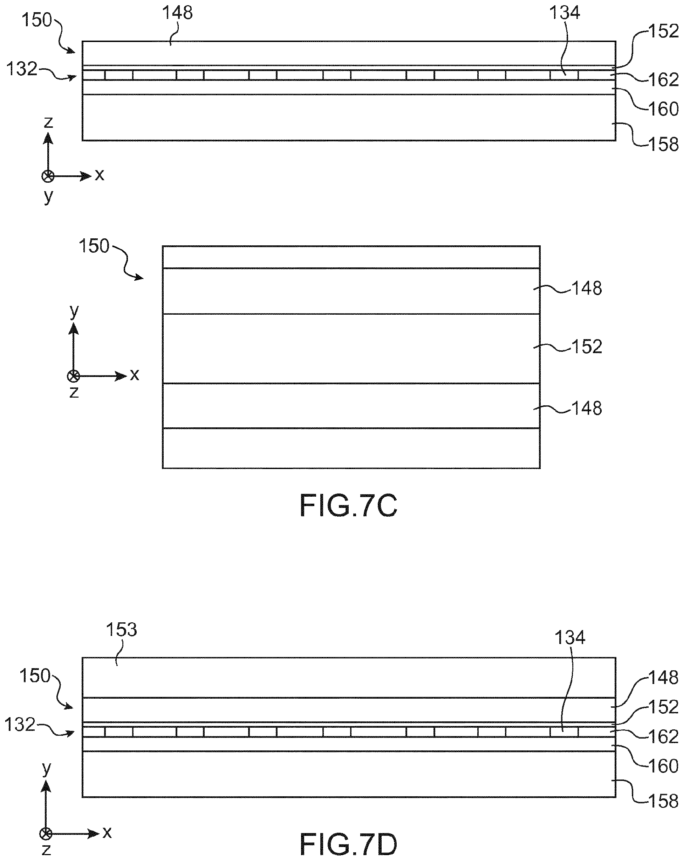

Le niveau conducteur 150 est ensuite réalisé. Pour cela, un empilement de couches comprenant la couche diélectrique 152 et une couche électriquement conductrice, par exemple métallique ou comprenant du polysilicium dopé, est réalisé sur les éléments de détection 134 et le matériau diélectrique 162. La couche électriquement conductrice est ensuite gravé avec arrêt sur la couche diélectrique 152 afin de former les cinquièmes portions conductrices 148 destinées à commander le passage des porteurs de charges dans les barrières tunnels 140 destinées à relier les détecteurs de charge 134 aux portions dopées 138 (figure 7C).

Un matériau diélectrique, par exemple de l'oxyde de semi-conducteur, est ensuite déposé sur le niveau conducteur 150, et notamment entre les cinquièmes portions conductrices 148, puis planarisé pour former des portions isolant les cinquièmes portions conductrices 148 ainsi que la couche diélectrique 153 (figure 7D).

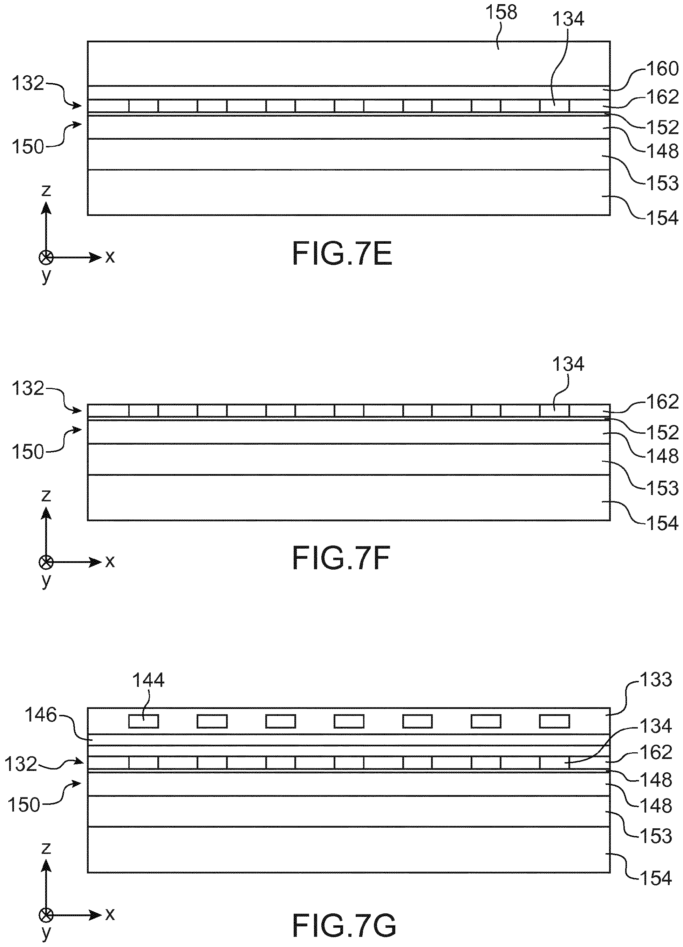

L'ensemble est ensuite retourné et solidarisé sur la couche support 154 destiné au maintien mécanique de l'ensemble (figure 7E).

Les couches 158 et 160 du substrat initial sont ensuite retirées, révélant la face arrière de la deuxième couche de semi-conducteur 132, et rendant accessible les détecteurs de charge 134 (figure 7F).

Les portions conductrices 144 et 146 ainsi que les grilles 142 sont ensuite réalisées par la mise en œuvre de plusieurs étapes de dépôt et de gravure de matériaux conducteurs (par exemple du polysilicium ou des matériau de grille métallique tels que du TiN ou du tungstène), et plusieurs dépôts intermédiaires d'un matériau diélectrique et des planarisations (ou des dépôts d'un oxyde planarisant de type HSQ, ou hydrogène-silsesquioxane) pour former la couche diélectrique 133 (figure 7G). L'épaisseur de l'ensemble formé des portions conductrices 144, 146 et de la couche diélectrique 133 est par exemple comprise entre environ 5 nm et 20 nm.

Des vias 164 sont ensuite réalisés à travers la couche diélectrique 133 et les matériaux conducteurs des portions 144, 146 et des grilles 142 afin de former les emplacements des portions de semi-conducteur 136. Ces vias 164 sont réalisés par la mise en œuvre d'une gravure avec arrêt sur le semi-conducteur de la couche 132.

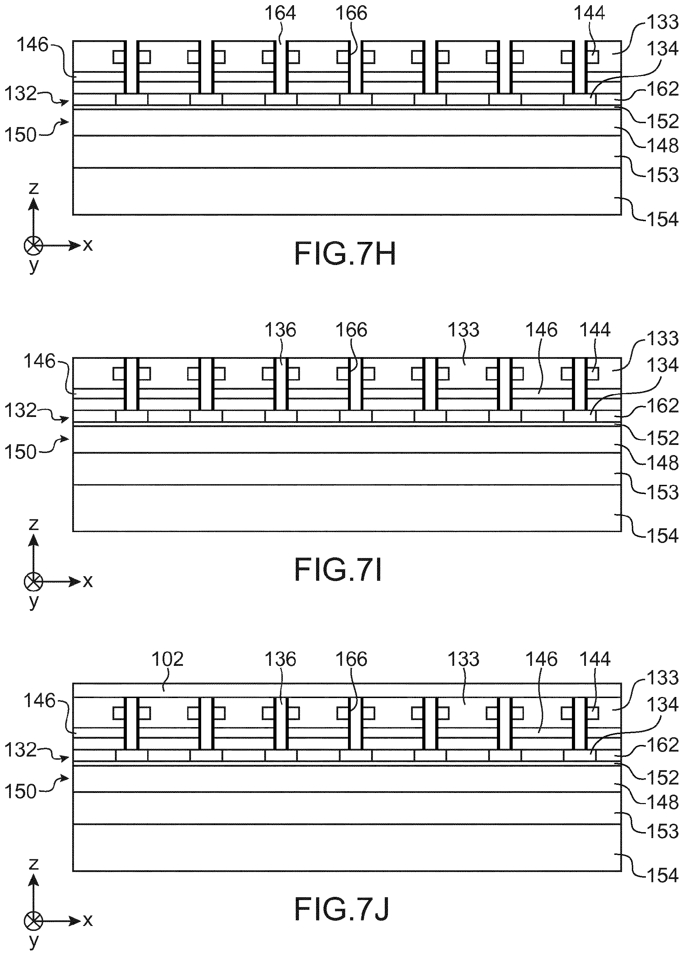

Du matériau diélectrique, par exemple un oxyde de semi-conducteur tel que du SiO₂ ou du nitrure de semi-conducteur, est ensuite déposé, en recouvrant notamment les parois latérales des vias 164. Une gravure anisotrope est ensuite mise en œuvre afin de conserver uniquement des parties 166 de ce matériau diélectrique disposées contre les parois latérales des vias 164 (figure 7H). Ces parties de matériau diélectrique 166 sont destinées à former les diélectriques de grille entre les grilles 142 et les portions de semi-conducteur 136.

Après un nettoyage, une épitaxie de semi-conducteur est mise en œuvre pour former les portions 136. La réalisation des portions 136 comporte également la mise en œuvre d'un planarisation mécano-chimique avec arrêt sur la couche diélectrique 133 afin de supprimer le semi-conducteur obtenu par croissance se trouvant en dehors des vias 164 (figure 7I).

La couche de semi-conducteur 102 est ensuite formée sur la face supérieure de l'ensemble formé par la couche diélectrique 133, les portions de semi-conducteur 136 et les parties 166 de ce matériau diélectrique, par exemple via un collage direct hydrophobe ou hydrophile (figure 7J).

Les qubits de donnée et de mesure 104, 106 sont ensuite formés dans la couche de semi-conducteur 102 par gravure.

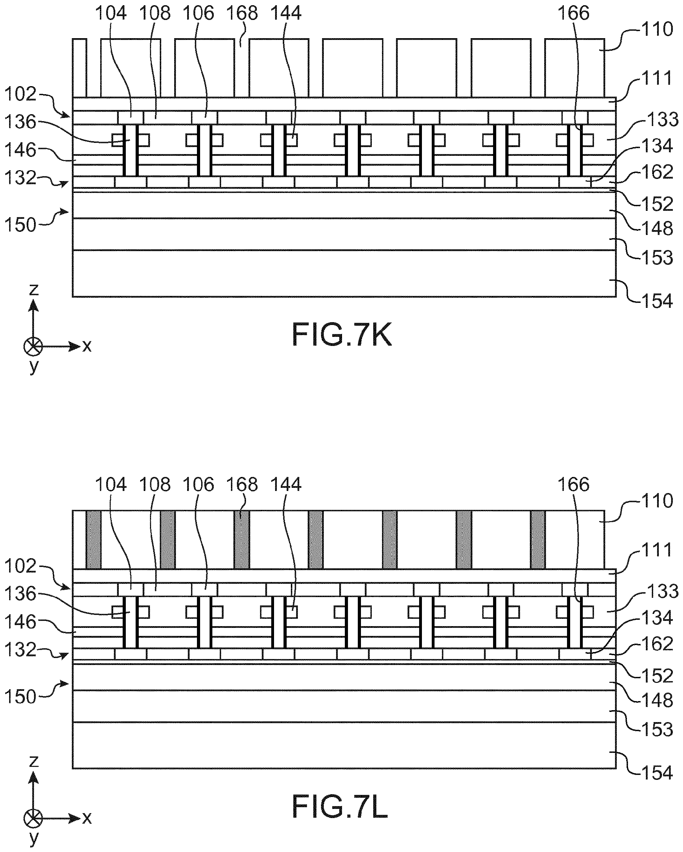

La couche diélectrique 111 est ensuite réalisée, puis une partie du matériau diélectrique 110, par exemple du SiO₂, est également réalisé sur la couche diélectrique 111. Des vias 168 sont alors réalisés à travers le matériau diélectrique 110, la couche diélectrique 111 étant par exemple de nature à servir de couche d'arrêt à cette gravure (figure 7K). La couche diélectrique 111 comporte par exemple du nitrure ou un bicouche oxyde de silicium/nitrure tel que le nitrure, servant de matériau d'arrêt, puisse être gravé ensuite à l'issu de la gravure servant à la réalisation des vias 118, 126.

Du matériau conducteur est ensuite déposé dans les vias 168, formant les vias conducteurs 118 (figure 7L).

Les niveaux de métallisations 112, 114 sont achevés en mettant en œuvre successivement une étape de dépôt et de gravure d'un matériau conducteur pour former les portions conductrices 116, puis le dépôt et la gravure d'une autre partie du matériau diélectrique 110 pour la réalisation des vias 126, et enfin des étapes de dépôt et gravure d'un matériau conducteur pour former les portions conductrices 124.

La structure obtenue à l'issue de ces étapes correspond à celle représentée sur la figure 4.

## Revendications

1. Dispositif quantique (100) à qubits de spin, comportant au moins :
- une première couche de semi-conducteur (102) comprenant une première matrice de qubits de donnée (104) et de qubits de mesure (106) reliés entre eux par des barrières tunnels (108) ;
- des moyens d'adressage des qubits de donnée (104) et des qubits de mesure (106) configurés pour contrôler par effet de champ la conduction de chacune des barrières tunnels (108) et comprenant au moins :
• des premières et deuxièmes portions électriquement conductrices (116, 124) disposées respectivement dans un premier et un deuxième niveaux de métallisations (112, 114) superposés ;
• des premiers et deuxièmes vias électriquement conducteurs (118, 126) comportant chacun une première extrémité (120, 128) reliée respectivement à l'une des premières et deuxièmes portions électriquement conductrices (118, 126), et une deuxième extrémité (122, 130) disposée en regard de l'une des barrières tunnels (108) ;
- une première couche diélectrique (111) interposée entre les barrières tunnels (108) et les deuxièmes extrémités (122, 130) des premiers et deuxièmes vias électriquement conducteurs (118, 126) ;
et comportant en outre :
- dans une première configuration, une deuxième couche de semi-conducteur (132) comprenant une deuxième matrice de détecteurs de charge (134), chacun des qubits de mesure (106) étant relié électriquement à un des détecteurs de charge (134) par une première portion de semi-conducteur (136) s'étendant entre les première et deuxième couches de semi-conducteur (102, 132), chacune des premières portions de semi-conducteur (136) étant couplée à au moins une grille (142a, 142b) configurée pour contrôler un couplage tunnel entre le détecteur de charge (134) et le qubit de mesure (106) reliés par ladite première portion de semi-conducteur (136), ou
- dans une deuxième configuration, une deuxième couche de semi-conducteur (132) et une deuxième matrice de détecteurs de charge (134) formés par des deuxièmes portions de semi-conducteur s'étendant entre les première et deuxième couches de semi-conducteur (102, 132), chacune desdites deuxièmes portions de semi-conducteur étant reliée par au moins une troisième barrière tunnel (156) à au moins un des qubits de mesure (106) disposés, dans le plan de la première couche de semi-conducteur (102), autour de ladite deuxième portion de semi-conducteur.

2. Dispositif quantique (100) selon la revendication 1, dans lequel :
- dans la première matrice, les qubits de donnée (104) et les qubits de mesure (106) sont alignés selon une première et une deuxième directions perpendiculaires l'une par rapport à l'autre, formant des lignes et des colonnes de la première matrice ;
- les deuxièmes extrémités (122) des premiers vias électriquement conducteurs (118) sont disposées en regard d'une partie des barrières tunnels (108), appelées premières barrières tunnels (108), reliant chacune un des qubits de donnée (104) et un des qubits de mesure (106) voisins et disposés sur une même ligne de la première matrice ;
- les deuxièmes extrémités (130) des deuxièmes vias électriquement conducteurs (126) sont disposées en regard d'une autre partie des barrières tunnels (108), appelées deuxièmes barrières tunnels (108), reliant chacune un des qubits de donnée (104) et un des qubits de mesure (106) voisins et disposés sur une même colonne de la première matrice.

3. Dispositif quantique (100) selon la revendication 2, dans lequel chacune des premières portions électriquement conductrices (116) est reliée aux premières extrémités (120) des premiers vias conducteurs (118) dont les deuxièmes extrémités (122) sont disposées en regard des premières barrières tunnels (108) reliant des qubits de données (104) et des qubits de mesure (106) disposés sur deux colonnes voisines de la première matrice, et dans lequel chacune des deuxièmes portions électriquement conductrices (124) est reliée aux premières extrémités (128) des deuxièmes vias conducteurs (126) dont les deuxièmes extrémités (130) sont disposées en regard des deuxièmes barrières tunnels (108) reliant des qubits de données (104) et des qubits de mesure (106) disposés sur deux lignes voisines de la première matrice.

4. Dispositif quantique (100) selon la revendication 2, dans lequel le dispositif quantique (100) est dans la première configuration et chacune des premières portions de semi-conducteur (136) est couplée à une première grille (142a) et à une deuxième grille (142b) configurées pour contrôler un couplage tunnel entre le détecteur de charge (134) et le qubit de mesure (106) reliés par ladite première portion de semi-conducteur (136) et qui sont distinctes et espacées l'une de l'autre, et dans lequel le dispositif quantique (100) comporte en outre :
- des troisièmes portions électriquement conductrices (144) chacune reliée aux premières grilles (142a) disposées autour des premières portions de semi-conducteur (136) reliées au moins aux qubits de mesure (106) disposés sur une même colonne de la première matrice ;
- des quatrièmes portions électriquement conductrices (146) chacune reliée aux deuxièmes grilles (142b) disposées autour des premières portions de semi-conducteur (136) reliées au moins aux qubits de mesure (106) disposés sur une même ligne de la première matrice.

5. Dispositif quantique (100) selon la revendication 4, dans lequel les première et deuxièmes grilles (142a, 142b) sont enrobantes et chacune disposée autour d'une des premières portions de semi-conducteur (136).

6. Dispositif quantique (100) selon l'une des revendications 1 à 3, dans lequel le dispositif quantique (100) est dans la deuxième configuration et chacune des deuxièmes portions de semi-conducteur est reliée par au moins deux troisièmes barrières tunnels (156) à au moins deux qubits de mesure (106) disposés, dans le plan de la première couche de semi-conducteur, autour de ladite deuxième portion de semi-conducteur.

7. Dispositif quantique (100) selon l'une des revendications précédentes, dans lequel chacun des qubits de donnée (104) est relié à un des détecteurs de charge (134).

8. Dispositif quantique (100) selon l'une des revendications précédentes, dans lequel la première couche de semi-conducteur (102) est disposée entre la deuxième couche de semi-conducteur (132) et les premier et deuxième niveaux de métallisation (112, 114).

9. Dispositif quantique (100) selon l'une des revendications précédentes, dans lequel la deuxième couche de semi-conducteur (132) comporte en outre des portions dopées (138) configurées pour former des réservoirs de porteurs de charges auxquels les détecteurs de charge (134) sont reliés par l'intermédiaire de quatrièmes barrières tunnels (140).

10. Dispositif quantique (100) selon la revendication 9, dans lequel chacune des portions dopées (138) est reliée à plusieurs détecteurs de charge (134) disposés sur une même ligne ou une même colonne de la deuxième matrice.

11. Dispositif quantique (100) selon l'une des revendications 9 ou 10, comportant en outre des deuxièmes grilles configurées pour contrôler par effet de champ la conduction de chacune des quatrièmes barrières tunnels (140).

12. Dispositif quantique (100) selon la revendication 11, dans lequel les deuxièmes grilles sont formées par des cinquièmes portions électriquement conductrices (148) s'étendant parallèlement aux lignes ou aux colonnes de la première matrice, disposées en regard des quatrièmes barrières tunnel (140) et espacées des quatrièmes barrières tunnel (140) par une deuxième couche diélectrique (152).

13. Dispositif quantique (100) selon la revendication 12, dans lequel les cinquièmes portions électriquement conductrices (148) sont formées dans un niveau conducteur (150) tel que la deuxième couche de semi-conducteur (132) soit disposée entre la première couche de semi-conducteur (102) et le niveau conducteur (150).

14. Procédé de réalisation d'un dispositif quantique (100) à qubits de spin, comprenant au moins les étapes de :
- réalisation, dans une première couche de semi-conducteur (102), d'une première matrice de qubits de donnée (104) et de qubits de mesure (106) reliés entre eux par des barrières tunnels (108) ;
- réalisation d'une première couche diélectrique (111) sur la première couche de semi-conducteur (102) ;
- réalisation de premières et deuxièmes portions électriquement conductrices (116, 124) disposées respectivement dans un premier et un deuxième niveaux de métallisation (112, 114) superposés ;
- réalisation de premiers et deuxièmes vias électriquement conducteurs (118, 126) comportant chacun une première extrémité (120, 128) reliée respectivement à l'une des premières et deuxièmes portions électriquement conductrices (118, 126), et une deuxième extrémité (122, 130) disposée en regard de l'une des barrières tunnels (108) telle que la première couche diélectrique (111) soit interposée entre les barrières tunnels (108) et les deuxièmes extrémités (122, 130) des premiers et deuxièmes vias électriquement conducteurs (118, 126) ;
et comportant en outre :
- dans une première configuration, une réalisation d'une deuxième matrice de détecteurs de charge (134) dans une deuxième couche de semi-conducteur (132), chacun des qubits de mesure (106) étant relié électriquement à un des détecteurs de charge (134) par une première portion de semi-conducteur (136) s'étendant entre les première et deuxième couches de semi-conducteur (102, 132), chacune des premières portions de semi-conducteur (136) étant couplée à au moins une grille (142a, 142b) configurée pour contrôler un couplage tunnel entre le détecteur de charge (134) et le qubit de mesure (106) reliés par ladite première portion de semi-conducteur (136), ou
- dans une deuxième configuration, une réalisation d'une deuxième matrice de détecteurs de charge (134) formés par des deuxièmes portions de semi-conducteur s'étendant entre la première couche de semi-conducteur (102) et une deuxième couche de semi-conducteur (132), chacune desdites deuxièmes portions de semi-conducteur étant reliée par au moins une troisième barrière tunnel (156) à au moins un des qubits de mesure (106) disposés, dans le plan de la première couche de semi-conducteur (102), autour de ladite deuxième portion de semi-conducteur.

## Patentansprüche

1. Quantenvorrichtung (100) mit Spin-Qubits, zumindest enthaltend:
- eine erste Halbleiterschicht (102) mit einer ersten Matrix von Daten-Qubits (104) und Maß-Qubits (106), die über Tunnelbarrieren (108) miteinander verbunden sind;
- Mittel zum Adressieren der Daten-Qubits (104) und der Maß-Qubits (106), die dazu ausgelegt sind, die Leitung jeder der Tunnelbarrieren (108) durch Feldeffekt zu steuern, und die zumindest enthalten:
• erste und zweite elektrisch leitende Abschnitte (116, 124), die jeweils in einer ersten bzw. zweiten darüber liegenden Metallisierungsebene (112, 114) angeordnet sind;
• erste und zweite elektrisch leitende Durchkontaktierungen (118, 126), die jeweils ein erstes Ende (120, 128) aufweisen, das mit einem der ersten bzw. zweiten elektrisch leitenden Abschnitte (118, 126) verbunden ist, sowie ein zweites Ende (122, 130), das einer der Tunnelbarrieren (108) gegenüberliegend angeordnet ist;
- eine erste dielektrische Schicht (111), die zwischen den Tunnelbarrieren (108) und den zweiten Enden (122, 130) der ersten bzw. zweiten elektrisch leitenden Durchkontaktierungen (118, 126) eingefügt ist;
und ferner enthaltend:
- in einer ersten Konfiguration eine zweite Halbleiterschicht (132), die eine zweite Matrix von Ladungsdetektoren (134) aufweist, wobei jedes der Maß-Qubits (106) über einen ersten Halbleiterabschnitt (136), der sich zwischen der ersten und der zweiten Halbleiterschicht (102, 132) erstreckt, mit einem der Ladungsdetektoren (134) elektrisch verbunden ist, wobei jeder der ersten Halbleiterabschnitte (136) mit zumindest einem Gatter (142a, 142b) gekoppelt ist, das dazu ausgelegt ist, eine Tunnelkopplung zwischen dem Ladungsdetektor (134) und dem Maß-Qubit (106) zu steuern, die über den ersten Halbleiterabschnitt (136) verbunden sind, oder
- in einer zweiten Konfiguration eine zweite Halbleiterschicht (132) und eine zweite Matrix von Ladungsdetektoren (134), die aus zweiten Halbleiterabschnitten gebildet sind, die sich zwischen der ersten und der zweiten Halbleiterschicht (102, 132) erstrecken, wobei jeder der zweiten Halbleiterabschnitte über zumindest eine dritte Tunnelbarriere (156) mit zumindest einem der Maß-Qubits (106) verbunden ist, die in der Ebene der ersten Halbleiterschicht (102) um den zweiten Halbleiterabschnitt herum angeordnet sind.

2. Quantenvorrichtung (100) nach Anspruch 1, wobei:
- in der ersten Matrix die Daten-Qubits (104) und die Maß-Qubits (106) entlang einer ersten und einer dazu senkrechten zweiten Richtung ausgerichtet sind und Zeilen und Spalten der ersten Matrix bilden;
- die zweiten Enden (122) der ersten elektrisch leitenden Durchkontaktierungen (118) einem Teil der Tunnelbarrieren (108), erste Tunnelbarrieren (108) genannt, gegenüberliegend angeordnet sind, die jeweils eines der Daten-Qubits (104) und eines der benachbarten Maß-Qubits (106) verbinden und auf derselben Zeile der ersten Matrix angeordnet sind;
- die zweiten Enden (130) der zweiten elektrisch leitenden Durchkontaktierungen (126) einem weiteren Teil der Tunnelbarrieren (108), zweite Tunnelbarrieren (108) genannt, gegenüberliegend angeordnet sind, die jeweils eines der Daten-Qubits (104) und eines der benachbarten Maß-Qubits (106) verbinden und auf derselben Spalte der ersten Matrix angeordnet sind.

3. Quantenvorrichtung (100) nach Anspruch 2, wobei jeder der ersten elektrisch leitenden Abschnitte (116) mit den ersten Enden (120) der ersten leitenden Durchkontaktierungen (118) verbunden ist, deren zweite Enden (122) den ersten Tunnelbarrieren (108) gegenüberliegend angeordnet sind, die Daten-Qubits (104) und Maß-Qubits (106) verbinden, die auf zwei benachbarten Spalten der ersten Matrix angeordnet sind, und wobei jeder der zweiten elektrisch leitenden Abschnitte (124) mit den ersten Enden (128) der zweiten leitenden Durchkontaktierungen (126) verbunden ist, deren zweite Enden (130) den zweiten Tunnelbarrieren (108) gegenüberliegend angeordnet sind, die Daten-Qubits (104) und Maß-Qubits (106) verbinden, die auf zwei benachbarten Zeilen der ersten Matrix angeordnet sind.

4. Quantenvorrichtung (100) nach Anspruch 2, wobei sich die Quantenvorrichtung (100) in einer ersten Konfiguration befindet und jeder der ersten Halbleiterabschnitte (136) mit einem ersten Gatter (142a) und einem zweiten Gatter (142b) gekoppelt ist, die dazu ausgelegt sind, eine Tunnelkopplung zwischen dem Ladungsdetektor (134) und dem Maß-Qubit (106) zu steuern, die über den ersten Halbleiterabschnitt (136) verbunden sind, und die voneinander getrennt und beabstandet sind, und wobei die Quantenvorrichtung (100) ferner enthält:
- dritte elektrisch leitende Abschnitte (144), die jeweils mit den ersten Gattern (142a) verbunden sind, die um die ersten Halbleiterabschnitte (136) herum angeordnet sind, die zumindest mit den Maß-Qubits (106) verbunden sind, die auf derselben Spalte der ersten Matrix angeordnet sind;
- vierte elektrisch leitende Abschnitte (146), die jeweils mit den zweiten Gattern (142b) verbunden sind, die um die ersten Halbleiterabschnitte (136) herum angeordnet sind, die zumindest mit den Maß-Qubits (106) verbunden sind, die auf derselben Zeile der ersten Matrix angeordnet sind.

5. Quantenvorrichtung (100) nach Anspruch 4, wobei das erste und das zweite Gatter (142a, 142b) als Umhüllung ausgebildet sind und jeweils um einen der ersten Halbleiterabschnitte (136) herum angeordnet sind.

6. Quantenvorrichtung (100) nach einem der Ansprüche 1 bis 3, wobei die Quantenvorrichtung (100) sich in der zweiten Konfiguration befindet und jeder der zweiten Halbleiterabschnitte über zumindest zwei dritte Tunnelbarrieren (156) mit zumindest zwei Maß-Qubits (106) verbunden ist, die in der Ebene der ersten Halbleiterschicht um den zweiten Halbleiterabschnitt herum angeordnet sind.

7. Quantenvorrichtung (100) nach einem der vorangehenden Ansprüche, wobei jedes der Daten-Qubits (104) mit einem der Ladungsdetektoren (134) verbunden ist.

8. Quantenvorrichtung (100) nach einem der vorangehenden Ansprüche, wobei die erste Halbleiterschicht (102) zwischen der zweiten Halbleiterschicht (132) und der ersten und zweiten Metallisierungsebene (112, 114) angeordnet ist.

9. Quantenvorrichtung (100) nach einem der vorangehenden Ansprüche, wobei die zweite Halbleiterschicht (132) ferner dotierte Abschnitte (138) aufweist, die dazu ausgelegt sind, Ladungsträgerreservoirs zu bilden, mit denen die Ladungsdetektoren (134) über vierte Tunnelbarrieren (140) verbunden sind.

10. Quantenvorrichtung (100) nach Anspruch 9, wobei jeder der dotierten Abschnitte (138) mit mehreren Ladungsdetektoren (134) verbunden ist, die in derselben Zeile bzw. derselben Spalte der zweiten Matrix angeordnet sind.

11. Quantenvorrichtung (100) nach einem der Ansprüche 9 oder 10, ferner enthaltend zweite Gatter, die dazu ausgelegt sind, die Leitung jeder der vierten Tunnelbarrieren (140) durch Feldeffekt zu steuern.

12. Quantenvorrichtung (100) nach Anspruch 11, wobei die zweiten Gatter aus fünften elektrisch leitenden Abschnitten (148) gebildet sind, die sich parallel zu den Zeilen bzw. Spalten der ersten Matrix erstrecken, den vierten Tunnelbarrieren (140) gegenüberliegend angeordnet sind und von den vierten Tunnelbarrieren (140) durch eine zweite dielektrische Schicht (152) beabstandet sind.

13. Quantenvorrichtung (100) nach Anspruch 12, wobei die fünften elektrisch leitenden Abschnitte (148) in einer leitenden Ebene (150) ausgebildet sind, so dass die zweite Halbleiterschicht (132) zwischen der ersten Halbleiterschicht (102) und der leitenden Ebene (150) angeordnet ist.

14. Verfahren zur Herstellung einer Quantenvorrichtung (100) mit Spin-Qubits, das zumindest die folgenden Schritte umfasst:
- Ausbilden einer ersten Matrix von Daten-Qubits (104) und Maß-Qubits (106), die über Tunnelbarrieren (108) miteinander verbunden sind, in einer ersten Halbleiterschicht (102);
- Ausbilden einer ersten dielektrischen Schicht (111) auf der ersten Halbleiterschicht (102); und
- Ausbilden von ersten und zweiten elektrisch leitenden Abschnitten (116, 124), die jeweils in einer ersten bzw. einer zweiten darüber liegenden Metallisierungsebene (112, 114) angeordnet sind;
- Ausbilden von ersten und zweiten elektrisch leitenden Durchkontaktierungen (118, 126), die jeweils ein erstes Ende (120, 128), das mit einem der ersten bzw. zweiten elektrisch leitenden Abschnitte (118, 126) verbunden ist, und ein zweites Ende (122, 130) aufweisen, das einer der Tunnelbarrieren (108) gegenüberliegend angeordnet ist, so dass die erste dielektrische Schicht (111) zwischen den Tunnelbarrieren (108) und den zweiten Enden (122, 130) der ersten und zweiten elektrisch leitenden Durchkontaktierungen (118, 126) eingefügt ist;
und das ferner umfasst:
- in einer ersten Konfiguration Ausbilden einer zweiten Matrix von Ladungsdetektoren (134) in einer zweiten Halbleiterschicht (132), wobei jedes der Maß-Qubits (106) über einen ersten Halbleiterabschnitt (136), der sich zwischen der ersten und der zweiten Halbleiterschicht (102, 132) erstreckt, mit einem der Ladungsdetektoren (134) elektrisch verbunden ist, wobei jeder der ersten Halbleiterabschnitte (136) mit zumindest einem Gatter (142a, 142b) gekoppelt ist, das dazu ausgelegt ist, eine Tunnelkopplung zwischen dem Ladungsdetektor (134) und dem Maß-Qubit (106) zu steuern, die über den ersten Halbleiterabschnitt (136) verbunden sind, oder
- in einer zweiten Konfiguration Ausbilden einer zweiten Matrix von Ladungsdetektoren (134), die aus zweiten Halbleiterabschnitten gebildet sind, die sich zwischen der ersten Halbleiterschicht (102) und einer zweiten Halbleiterschicht (132) erstrecken, wobei jeder der zweiten Halbleiterabschnitte über zumindest eine dritte Tunnelbarriere (156) mit zumindest einem der Maß-Qubits (106) verbunden ist, die in der Ebene der ersten Halbleiterschicht (102) um den zweiten Halbleiterabschnitt herum angeordnet sind.

## Claims

1. Quantum device (100) with spin qubits, comprising a least:
- a first semiconducting layer (102) comprising a first matrix of data qubits (104) and measurement qubits (106) connected to each other through tunnel barriers (108);
- means of addressing data qubits (104) and measurement qubits (106) configured for controlling conduction of each tunnel barrier (108) by the field effect and comprising at least:
• first and second electrically conducting portions (116, 124) arranged in first and second superposed metallisation levels (112, 114) respectively;
• first and second electrically conducting vias (118, 126) each comprising a first end (120, 128) connected to one of the first and second electrically conducting portions (118, 126) respectively, and a second end (122, 130) located facing one of the tunnel barriers (108);
- a first dielectric layer (111) interposed between the tunnel barriers (108) and the second ends (122, 130) of the first and second electrically conducting vias (118, 126);
and further comprising:
- in a first configuration, a second semiconducting layer (132) comprising a second charge detectors matrix (134), each of the measurement qubits (106) being electrically connected to one of the charge detectors (134) through a first semiconducting portion (136) extending between the first and second semiconducting layers (102, 132), each of the first semiconducting portions (136) being coupled to at least one gate (142a, 142b) configured for controlling tunnel coupling between the charge detector (134) and the measurement qubit (106) connected through said first semiconducting portion (136), or
- in a second configuration, a second semiconducting layer (132) and a second charge detectors matrix (134) formed from second semiconducting portions extending between the first and second semiconducting layers (102, 132), each of said second semiconducting portions being connected by at least one third tunnel barrier (156) to at least one of the measurement qubits (106), located in the plane of the first semiconducting layer (102), around said second semiconducting portion.

2. Quantum device (100) according to claim 1, in which:
- in the first matrix, the data qubits (104) and the measurement qubits (106) are aligned in first and second directions perpendicular to each other forming rows and columns of the first matrix;
- the second ends (122) of the first electrically conducting vias (118) are arranged facing some of the tunnel barriers (108) named first tunnel barriers (108), each connecting one of the data qubits (104) and one of the adjacent measurement qubits (106) and located on the same row of the first matrix;
- the second ends (130) of the second electrically conducting vias (126) are arranged facing some of the other tunnel barriers (108) named second tunnel barriers (108), each connecting one of the data qubits (104) and one of the adjacent measurement qubits (106) and located on the same column of the first matrix.

3. Quantum device (100) according to claim 2, in which each of the first electrically conducting portions (116) is connected to the first ends (120) of the first conducting vias (118), the seconds ends (122) of which are facing the first tunnel barriers (108) connecting the data qubits (104) and the measurement qubits (106) located on two adjacent columns of the first matrix, and in which each of the second electrically conducting portions (124) is connected to the first ends (128) of the second conductor vias (126), the second ends (130) of which are facing the second tunnel barriers (108) connecting the data qubits (104) and the measurement qubits (106) located on two adjacent rows of the first matrix.

4. Quantum device (100) according to claims 2, in which the quantum device (100) is in the first configuration and each of the first semiconducting portions (136) is coupled to a first gate (142a) and to a second gate (142b) configured for controlling tunnel coupling between the charge detector (134) and the measurement qubit (106) connected through said first semiconducting portion (136) and that are distinct and at a distance from each other, and in which the quantum device (100) also includes:
- third electrically conducting portions (144) each connected to first gates (142a) located around first semiconducting portions (136) connected at least to measurement qubits (106) located on the same column of the first matrix;
- fourth electrically conducting portions (146) each connected to second gates (142b) located around first semiconducting portions (136) connected at least to measurement qubits (106) located on the same row of the first matrix.

5. Quantum device (100) according to claim 4, in which the first and second gates (142a, 142b) are coating and each is located around one of the first semiconducting portions (136).

6. Quantum device (100) according to one of claims 1 to 3, in which the quantum device (100) is in the second configuration and each of the second semiconducting portions is connected by at least two third tunnel barriers (156) to at least two measurement qubits (106), located in the plane of the first semiconducting layer around said second semiconducting portion.

7. Quantum device (100) according to one of previous claims, in which each data qubit (104) is connected to one of the charge detectors (134).

8. Quantum device (100) according to one of previous claims, in which the first semiconducting layer (102) is located between the second semiconducting layer (132) and the first and second metallisation levels (112, 114).

9. Quantum device (100) according to one of previous claims, in which the second semiconducting layer (132) also comprises doped portions (138) configured for forming charge carrier reservoirs to which the charge detectors (134) are connected by means of fourth tunnel barriers (140).

10. Quantum device (100) according to claim 9, in which each of the doped portions (138) is connected to several charge detectors (134) arranged on a same row or a same column of the second matrix.

11. Quantum device (100) according to one of claims 9 or 10, also comprising second gates configured for controlling conduction of each of the fourth tunnel barriers (140) by the field effect.

12. Quantum device (100) according to claim 11, in which the second gates are formed by fifth electrically conducting portions (148) extending parallel to the rows or columns of the first matrix, arranged facing the fourth tunnel barriers (140) and spaced from the fourth tunnel barriers (140) by a second dielectric layer (152).

13. Quantum device (100) according to claim 12, in which the fifth electrically conducting portions (148) are formed in a conducting level (150) such that the second semiconducting layer (132) is located between the first semiconducting layer (102) and the conducting level (150).

14. Method of making a quantum device (100) with spin qubits, comprising at least the following steps:
- fabrication, in a first semiconducting layer (102), of a first matrix of data qubits (104) and measurement qubits (106) connected to each other through tunnel barriers (108);
- fabrication of a first dielectric layer (111) on the first semiconducting layer (102);
- fabrication of first and second electrically conducting portions (116, 124) arranged in first and second superposed metallisation levels (112, 114) respectively;
- fabrication of first and second electrically conducting vias (118, 126) each comprising a first end (120, 128) connected to one of the first and second electrically conducting portions (118, 126) respectively, and a second end (122, 130) facing one of the tunnel barriers (108) such that the first dielectric layer (111) is interposed between the tunnel barriers (108) and the second ends (122, 130) of the first and second electrically conducting vias (118, 126);
and further comprising:
- in a first configuration, fabrication of a second charge detectors matrix (134) in a second semiconducting layer (132), each of the measurement qubits (106) being electrically connected to one of the charge detectors (134) through a first semiconducting portion (136) extending between the first and second semiconducting layers (102, 132), each of the first semiconducting portions (136) being coupled to at least one gate (142a, 142b) configured for controlling tunnel coupling between the charge detector (134) and the measurement qubit (106) connected through said first semiconducting portion (136), or
- in a second configuration, fabrication of a second charge detectors matrix (134) formed from second semiconducting portions extending between the first semiconducting layer (102) and a second semiconducting layer (132), each of said second semiconducting portions being connected by at least one third tunnel barrier (156) to at least one of the measurement qubits (106), located in the plane of the first semiconducting layer (102), around said second semiconducting portion.
